# EUROPÄISCHE PATENTSCHRIFT

(11) **EP 0 447 798 B1**
(45) Veröffentlichungstag und Bekanntmachung des Hinweises auf die Patenterteilung: **06.09.1995**
(21) Anmeldenummer: 91102076.6
(22) Anmeldetag: 14.02.1991
(51) Int. Cl.: G01R 31/28

(54) **Prüfgerät für beidseitig mit integrierten Schaltungen bestückte Leiterplatten**
Test apparatus for printed circuits with IC's on both sides
Appareil de test pour des circuits imprimés portant des circuits intégrés sur ses deux faces

(30) Priorität: 19.03.1990 DE 4008771
(43) Veröffentlichungstag der Anmeldung: 25.09.1991
(73) Patentinhaber: SECATEC GmbH Berührungslose Schalttechnik, D-57581 Katzwinkel (DE)
(72) Erfinder: Brüser, Martin, W-5963 Wenden 2 (DE); Hils Rudolf, W-5240 Alsdorf (DE)
(74) Vertreter: Cohausz & Florack Patentanwälte

(56) Entgegenhaltungen:
- EP-A- 0 255 909
- EP-A- 0 261 829
- PATENT ABSTRACTS OF JAPAN vol. 6, no. 62 (P-111)(940) 21. April 1982

## Beschreibung

Die Erfindung bezieht sich auf ein Prüfgerät für beidseitig mit integrierten Schaltungen bestückte Leiterplatten, bestehend aus einem Halter für eine Leiterplatte, die mit Halteelementen des Halters nur am Rand erfaßt wird, und aus für jede Seite der Leiterplatten je einem eine Vielzahl von Kontaktstiften aufweisenden Meßkopf, sowie einer Positioniereinrichtung für die relative Lage von Meßkopf und Leiterplatte.

Bei einer bekannten Prüfeinrichtung (EP 0 255 909 A2) der eingangs genannten Art erstrecken sich die beidseitig der horizontal gehaltenen Leiterplatte angeordneten Meßköpfe über deren gesamte Fläche. Definierte Kontaktierzustände werden dadurch erreicht, daß zunächst die Leiterplatte auf den unteren Meßkopf abgesenkt und dann der obere Meßkopf auf die abgesenkte Leiterplatte abgesenkt wird. Damit die Leiterplatte dabei nicht unerwünscht stark auf Biegung beansprucht wird, wird sie durch eine Vielzahl von zwischen den Schaltungen beidseitig zu plazierenden Stützstiften der Meßköpfe eingespannt. Diese Konstruktion, bei der sowohl der obere Meßkopf, als auch die Leiterplatte in einer Bewegungsrichtung angetrieben werden und die Meßköpfe mit Stützstiften versehen sind, ist aufwendig und wegen der für die Platzierung der Stützstifte notwendigen freien Stellen auf der Leiterplatte nur beschränkt einsatzfähig.

Bei einem aus der Praxis bekannten ähnlichen Prüfgerät ist der Halter für die Leiterplatte schalenförmig ausgebildet und stützt die Leiterplatte an ihrem Rand ab. Solange die Leiterplatte auf jeder Seite nur komplette Schaltungen umfaßt, lassen sich die einzelnen Schaltungen nacheinander problemlos prüfen. Ist die eine Seite der Leiterplatte geprüft, erfolgt nach Wenden der Leiterplatte die Prüfung der Schaltungen der anderen Seite. Problematisch wird die Prüfung aber dann, wenn sich eine Schaltung aus auf beiden Seiten der Leiterplatten befindlichen Teilen zusammensetzt. In diesem Fall läßt sich eine Schaltung nur prüfen, wenn sie gleichzeitig auf beiden Seiten kontaktiert werden kann. Dieses Problem hat man in der Weise gelöst, daß der schalenförmige Halter für jeden von ihm abgedeckten Schaltungsteil der auf der Leiterplatte befindlichen Schaltungen mit Kontaktstiften bestückt ist, die die erforderlichen Kontaktbrücken für die Prüfung bei auf der frei zugänglichen Seite aufgesetztem Meßkopf bilden. Ein solches Prüfgerät ist wegen der vielen Sätze von Kontaktstiften für die verdeckten Schaltungsteile aufwendig.

Der Erfindung liegt die Aufgabe zugrunde, ein Prüfgerät für beidseitig mit integrierten Schaltungen bestückte Leiterplatten zu schaffen, bei dem der gerätetechnische Aufwand geringer als bei den bekannten Prüfgeräten ist.

Diese Aufgabe wird erfindungsgemäß bei einem Prüfgerät der eingangs genannten Art dadurch gelöst, daß die Halteelemente die Leiterplatte unter Bildung eines freien Arbeitsraums in festem Abstand über einem Sockel halten, daß die beiden Meßköpfe an einem Träger mittels nachgiebiger Anschläge in Absenkrichtung auf die Leiterplatte schwimmend gelagert sind, und daß sie in ihrem gegenseitigen Abstand mittels eines Stellgliedes einstellbar und zangenartig auf die zu prüfenden Schaltungen aufsetzbar sind.

Bei dem erfindungsgemäßen Prüfgerät läßt sich das Meßkopfpaar zangenartig auf die zu prüfende Schaltung aufsetzen. Die damit verbundene Belastung der Leiterplatte, insbesondere der bei einer Ausführung in Keramik bruchempfindlichen Leiterplatte ist gering, weil wegen der schwimmenden Lagerung und der Kopplung der Meßköpfe über das Stellglied sich das Meßkopfpaar auf die Lage der Leiterplatte selbständig einstellt. So fängt der nachgieibige Anschlag für den oberen Meßkopf dessen Gewicht und, nachdem das Stellglied angesprochen hat, auch das Gewicht des unteren Meßkopfes ab, so daß praktisch ohne einseitige Belastung die Kontaktstifte auf die Leiterplatte aufsetzen und den erforderlichen Kontaktdruck aufbringen.

Um das Meßkopfpaar gegenüber den einzelnen Schaltungen auf der Leiterplatte zu positionieren, ist vorzugsweise die Positioniereinrichtung als ein in zwei zueinander senkrechten Achsen verfahrbarer, den Sockel bildender Kreuztisch ausgebildet. Grundsätzlich ist es zwar auch möglich, die erforderliche Relativbewegung zwischen dem Meßkopfpaar und der Leiterplatte durch gemeinsames Verfahren der Meßköpfe vorzunehmen, doch da diese schon angehoben und abgesenkt werden, läßt sich die Relativbewegung in der Ebene der Leiterplatte leichter durch die Bewegung der Leiterplatte erreichen.

Nach einer Ausgestaltung der Erfindung ist das Stellglied ein zwischen den Meßköpfen wirksamer Stellzylinder. Da die genaue Position der Leiterplatte durch die Halteelemente vorgegeben ist, läßt sich auch die Endposition der Meßköpfe vorgeben, so daß es nicht erforderlich ist, über das Stellglied den Kontaktdruck einzustellen. Dies läßt sich nach einer weiteren Ausgestaltung der Erfindung dadurch verwirklichen, daß jedem Meßkopf ein in Absenkrichtung wirksamer fester Anschlag zugeordnet ist.

Im folgenden wird die Erfindung anhand eines ein Ausführungsbeispiel schematisch in Seitenansicht darstellenden Prüfgerätes erläutert.

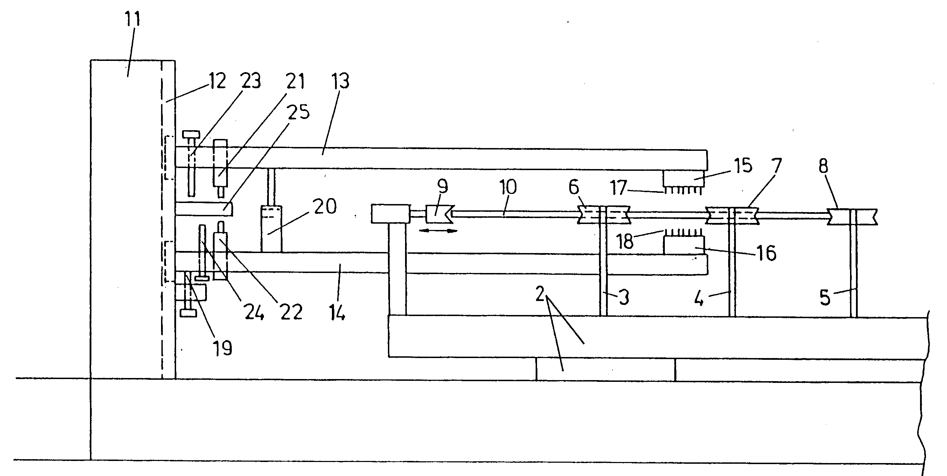

Auf einer Grundplatte 1 ist ein als Kreuztisch ausgebildeter Sockel 2 in der Horizontalen in zwei zueinander senkrechten Achsen verfahrbar. Der Sockel 2 trägt auf Stäben 3,4,5 zwei Paar Keilrollen 6,7,8, von denen die beiden Paare unter einem rechten Winkel angeordnet sind. Diesen Keilrollen 6,7,8 ist ein Spannglied 9 zugeordnet. Die Keilrollen 6 bis 8 und das Spannglied 9 bilden Halteelemente für eine auf beiden Seiten mit einer Vielzahl von integrierten Schaltungen bestückte Leiterplatte 10. Die Leiterplatte 10 liegt mit zwei unter einem rechten Winkel angeordneten Rändern an den Keilrollen 6 und 7 beziehungsweise 8 an und wird durch das an der Diagonalen liegenden Spitze angreifende Spannglied 9 ausgerichtet gehalten.
Auf der Bodenplatte 1 ist eine Tragsäule 11 angeordnet, bei der in einer vertikalen Führung 12 zwei Arme 13,14 verschieblich gelagert sind. Die Arme 13,14 tragen an ihren freien Enden Meßköpfe 15,16, die jeweils mit aufeinander zugerichteten Kontaktstiften 17,18 bestückt sind. Der eine Meßkopf 15 befindet sich oberhalb der Leiterplatte 10 und der andere in dem unter der Leiterplatte 10 befindlichen freien Arbeitsraum.
In der in der Zeichnung befindlichen Position ist der untere Arm 14 an einem einstellbaren Anschlag 19 abgestützt, so daß die Kontaktstifte 18 einen ausreichend großen Abstand von der Leiterplatte 10 haben, um die Leiterplatte 10 ohne Behinderung verfahren zu können. Der obere Arm 13 wird in der in der Zeichnung dargestellten Position durch ein als doppelseitig beaufschlagbare Zylinderkolbenanordnung ausgebildetes Stellglied 20 gehalten, das zwischen den beiden Armen 13,14 wirksam ist. Sowohl der obere Arm 13 als auch der untere Arm 14 haben jeweils einen nachgiebigen, als Dämpfungsglied wirkenden Anschlag 21,22 und einen einstellbaren festen Anschlag 23,24. Diese Anschläge 21 bis 24 wirken mit einem von der Säule 1 getragenen Stützelement 25 zusammen.

Die Arbeitsweise des Prüfgerätes ist folgende:

Nachdem die Leiterplatte 10 von den Halteelementen 6 bis 8 und dem Spannelement 9 positioniert und eingespannt ist, wird der Kreuztisch mit seinem Sockel 2 verfahren, so daß sich die Leiterplatte 10 zwischen dem oberen und unteren Meßkopf 15,16 befindet, wie in der Zeichnung dargestellt ist. Nachdem der Kreuztisch die Leiterplatte 10 bezüglich einer Schaltung gegenüber den Meßköpfen 15,16 positioniert hat, wird das Stellglied 20 druckentlastet, so daß der Arm 13 mit dem Meßkopf 15 sich aufgrund seines Eigengewichtes absenkt, bis daß der nachgiebige Anschlag 21 durch Abstützung an der Stütze 25 den Arm 13 zu tragen imstande ist. In dieser Position haben die Kontaktstifte 17 die Leiterplatte noch nicht berührt. Anschließend erfolgt die Druckbeaufschlagung des Stellgliedes 20, wodurch der Arm 14 von dem Anschlag 19 abhebt und der nachgiebige Anschlag 22 zur Anlage an der Stütze 25 kommt. Da nach Abheben des unteren Armes 14 vom Anschlag 19 der untere Arm über das Stellglied 20 am oberen Arm 13 aufgehängt ist, muß der nachgiebige Anschlag 21 das gesamte Eigengewicht der beiden Arme 13,14 und der Meßköpfe 15,16 aufnehmen. Deshalb sollte seine Vorspannung so eingestellt sein, daß er das gesamte Eigengewicht tragen kann, ohne daß es schon zu einer Berührung der Kontaktstifte 17 kommt. Bei andauernder Druckbeaufschlagung des Stellgliedes 20 kommt auch der untere nachgiebige Anschlag 22 zur Anlage an der Stütze 25. Die Vorspannung dieses nachgiebigen Anschlages 22 ist auf die Vorspannung des oberen nachgiebigen Anschlages 21 derart abgestimmt, daß sich eine praktisch schwimmende Lagerung der beiden Arme 13,14 in vertikaler Richtung ergibt. Deshalb setzen die Kontaktstifte 17,18 bei weiterer Druckbeaufschlagung des Stellgliedes 20 praktisch kraftlos auf die Schaltungen der Leiterplatte 10 auf, ohne daß die Leiterplatte 10 von der einen oder anderen Seite einseitig auf Druck belastet wird. Wegen der schwimmenden Lagerung kommt es auch bei weiterer Druckbeaufschlagung nicht zu einem einseitig wirkenden Druck, vielmehr wird der von den oberen Kontaktstiften 17 auf die Leiterplatte 10 ausgeübte Druck von dem von den unteren Kontaktstiften 18 auf die Leiterplatte ausgeübten Gegendruck wie bei einer Zange kompensiert. Bei weiterer Druckbeaufschlagung kommen dann die starren Anschläge 23,24 zur Anlage an der Stütze 25. Sie sind so eingestellt, daß der erforderliche Kontaktdruck über die elastischen Kontaktstifte 17,18 aufgebracht werden kann.

Nachdem die gegenüberliegenden Schaltungen beziehungsweise Schaltungsteile geprüft sind, werden die Meßköpfe 15,16 durch entgegengesetzte Druckbeaufschlagung des doppelseitig beaufschlagbaren Stellgliedes 20 wieder auseinander gefahren und die Leiterplatte 10 mittels des Kreuztisches 2 in eine andere Position gegenüber den Meßköpfen 15,16 gebracht. Anschließend wiederholt sich der beschriebene Vorgang.

Das Prüfgerät eignet sich sowohl für die beidseitig mit integrierten Schaltungen bestückte Leiterplatte, bei denen die auf gegenüberliegenden Seiten liegenden Teile entweder gemeinsam eine einzige Schaltung oder zwei voneinander unabhängige Schaltungen bilden.

## Patentansprüche

1. Prüfgerät für beidseitig mit integrierten Schaltungen bestückte Leiterplatten (10), bestehend aus einem Halter (2-9) für eine Leiterplatte (10), die mit Halteelementen (3-9) des Halters (2-9) nur am Rand erfaßt wird, und aus für jede Seite der Leiterplatten (10) je einem eine Vielzahl von Kontaktstiften (17) aufweisenden Meßkopf (15, 16), sowie einer Positioniereinrichtung für die relative Lage von Meßkopf und Leiterplatte, **dadurch gekennzeichnet**, daß die Halteelemente (3-9) die Leiterplatte (10) unter Bildung eines freien Arbeitsraums in festem Abstand über einem Sockel (2) halten, daß die beiden Meßköpfe (15, 16) an einem Träger (11) mittels nachgiebiger Anschläge (21, 22) in Absenkrichtung auf die Leiterplatte schwimmend gelagert sind, und daß sie in ihrem gegenseitigen Abstand mittels eines Stellgliedes (20) einstellbar und zangenartig auf die zu prüfenden Schaltungen aufsetzbar sind.

2. Prüfgerät nach Anspruch 1, dadurch gekennzeichnet, daß die Positioniereinrichtung für die relative Lage der Meßköpfe (15, 16) und der Leiterplatte (10) in einer zu der Bewegungsrichtung der Meßköpfe (15, 16) senkrechten Ebene vorgesehen sind.

3. Prüfgerät nach Anspruch 2, **dadurch gekennzeichnet**, daß die Positioniereinrichtung ein den Sockel (2) bildender Kreuztisch ist.

4. Prüfgerät nach einem der Ansprüche 1 bis 3, **dadurch gekennzeichnet**, daß das Stellglied (20) eine zwischen den Meßköpfen (15, 16) wirksame Zylinderkolbeneinheit ist.

5. Prüfgerät nach einem der Ansprüche 1 bis 4, **dadurch gekennzeichnet**, daß jedem Meßkopf (15, 16) ein in Absenkrichtung wirksamer fester Anschlag (23, 24) zugeordnet ist.

## Claims

1. A test apparatus for printed circuits (10) having integrated circuits on both sides, the apparatus comprising: a holder (2-9) for a printed circuit (10) which is engaged only at the edge by retaining elements (3-9) of the holder (2-9); a measuring head (15, 16) having a plurality of contact pins (17) for each side of the printed circuit (10); and a positioning device for the relative position of the measuring head and circuit board, characterized in that the retaining elements (3-9) retain the printed circuit (10) at a fixed distance above a base (2), with the formation of a free working space; the two measuring heads (15, 16) are floatably mounted on a support (11) via yielding stops (21, 22) in the lowering direction on to the circuit board; and said measuring heads can be adjusted in their distance from one another by means of an adjusting member (20) and applied tongs-fashion to the circuits to be tested.

2. A test apparatus according to claim 1, characterized in that the positioning device for the relative position of the measuring heads (15, 16) and the printed circuit (10) is provided in a plane perpendicular to the direction of movement of the measuring heads (15, 16).

3. A test apparatus according to claim 2, characterized in that the positioning device is a cross table forming the base (2).

4. A test apparatus according to one of claims 1 to 3, characterized in that the adjusting member (20) is a piston-and-cylinder unit operative between the measuring heads (15, 16).

5. A test apparatus according to one of claims 1 to 4, characterized in that a fixed stop (23, 24) operative in the lowering direction is associated with each measuring head (15, 16).

## Revendications

1. Appareil de test pour des circuits imprimés (10) portant sur leurs deux faces des circuits intégrés, se composant d'un support (2-9) pour un circuit imprimé (10), qui n'est saisi que par le bord à l'aide d'éléments de soutien (3-9) du support (2-9), et, pour chaque côté des circuits imprimés (10), respectivement d'une tête de mesure (15,16) munie d'une pluralité de fiches de contact (17), ainsi que d'un dispositif de positionnement pour la situation relative de la tête de mesure et du circuit imprimé, caractérisé en ce que les éléments de soutien (3-9) tiennent le circuit imprimé (10) à une distance définie au-dessus d'un socle (2) en formant un espace de travail libre, en ce que les deux têtes de mesure (15,16) sont portées au moyen de butoirs souples (21,22), en direction descendante, sur le circuit imprimé flottant sur un support (11), et en ce que lesdites têtes, quant à leur distance réciproque, sont susceptibles d'être réglées à l'aide d'un organe de réglage (20) et d'être posées comme une pince, sur des circuits à tester.

2. Appareil de test selon la revendication 1, caractérisé en ce que le dispositif de positionnement pour la position relative des têtes de mesure (15,16) et du circuit imprimé est prévu d'être disposé perpendiculairement à la direction du mouvement des têtes de mesure (15,16).

3. Appareil de test selon la revendication 2, caractérisé en ce que le dispositif de positionnement est une table à mouvements croisés formant le socle (2).

4. Appareil de test selon une des revendications 1 à 3, caractérisé en ce que l'organe de réglage (20) est un ensemble piston-cylindre agissant entre les têtes de mesure (15,16).

5. Appareil de test selon une des revendications 1 à 4, caractérisé en ce qu'un butoir (23,24) fixe, agissant en direction descendante, est attribué à chaque tête de mesure (15,16).
